Europäisches Patentamt

European Patent Office

Office européen des brevets

(19)

(11) Publication number: **0 336 723**
**A1**

## (12) EUROPEAN PATENT APPLICATION

(21) Application number: **89303333.2**

(22) Date of filing: **04.04.89**

(51) Int. Cl.⁴: **G 11 C 5/00**
**G 11 B 33/12, H 04 B 5/00,**
**H 02 J 17/00**

(30) Priority: **08.04.88 GB 8808317**

(43) Date of publication of application:
**11.10.89 Bulletin 89/41**

(84) Designated Contracting States: **DE FR GB IT**

(71) Applicant: **GOLDEN RIVER LIMITED**
**Churchill Road**
**Bicester Oxfordshire OX6 7XT (GB)**

(72) Inventor: **Dalgleish, Michael**
**Foxcombe Rise Foxcombe Drive**
**Boars Hill Oxford OX1 5DN (GB)**

**Moreton, Robert**
**86 Tyrells Way Sutton Courtenay**
**Nr. Abingdon Oxfordshire (GB)**

**Fine, David**
**57 Stretford Road Wolverton**
**Milton Keynes Buckinghamshire (GB)**

(74) Representative: **Greene-Kelly, James Patrick et al**
**Marks & Clerk 57-60 Lincoln's Inn Fields**
**London WC2A 3LS (GB)**

(54) Data recording apparatus.

(57) A data storage device is disclosed having a data input circuit 13, 16, a data output circuit 14, 16 and a power supply circuit 11, 12, 15 all housed in a housing. The power supply circuit includes a coil 11, located internally on the housing without a physical connection to the exterior of the housing for receiving power from outside the housing by inductive coupling through the housing from a power supply coil forming part of a host device. Preferrably data is transmitted to and from the data storage device by means of radiation responsive elements 13, 14.

FIG.1.

EP 0 336 723 A1

# Description

## DATA RECORDING APPARATUS

When data is recorded at a plurality of locations and processed at a central station, and some of the recording locations are only temporary so that installation of land lines is uneconomic, it is usual to collect data from the recording locations and carry the data to the central processing station. The data can be recorded on conventional magnetic tape, or a semi-conductor device such as a RAM chip while being carried from the recording location to the processing station. It is preferably carried in a cartridge which obtains its power to record and store the data from the recordng location itself. The conventional method of connecting the data lines and the power supply lines is to use plugs and sockets, but in some environments these can easily become contaminated.

According to the present invention there is provided a data storage device having a data input circuit and a data output circuit and a power supply circuit, all housed in a housing, the power supply circuit comprising a coil located internally of the housing without a connection to the exterior of the housing, for receiving power from outside the cartridge by induction through the housing. In a preferred arrangement the housing has one or more windows and the data input and output circuits each comprise a diode for emitting or receiving radiation through a said window in the housing. The emitting diode may be a light emitting diode (LED). The power supply circuit may also comprise an LED operable in response to the state of the power supply circuit, for emitting radiation through a window in the housing in response to the state of the circuit.

In an alternative aspect of the invention, there is provided a data storage device having a data input circuit and a data output circuit and a power supply circuit, all contained in a housing having an end wall, the power supply circuit comprising a coil within the housing having an axis extending through the end wall, the data input circuit comprising a diode whose light receiving path extends through the end wall and the data output circuit comprising an LED whose light emitting path extends through the end wall, the points of intersection of the diodes with the end wall being 15mm apart and the point of intersection of the axis of the coil with the end wall being 30mm from one of the other points of intersection. The points of intersection are preferably aligned, that of the power coil axis being 30mm from that of the diode of the data input circuit. The power input circuit may comprise an LED responsive to the state of the power supply circuit, whose light emitting path has a point of intersection with the end wall of the housing at a point equally spaced between the point of intersection of the power coil access and the point of intersection of the data input diode. With this standard arrangement of coil and diodes, the cartridge can co-operate with any remote recording station and central data processing station built to this standard.

When the cartridge is carried to the remote recording station, it is placed in position on the remote recording station apparatus and receives power inductively from a coil in the remote recording station. The LED in the power supply circuit emits light at an intensity which depends on the energisation of the power supply circuit. When the remote recording station receives light of a sufficient intensity from the cartridge LED, it ceases to supply further energy to the cartridge. Data is then transmitted from the remote recording station to the cartridge through the receiving diode, and the cartridge is able to receive and store the data because its power supply circuit is fully energised.

A similar operation takes place at the central data processing station, except that the data is extracted from the cartridge through the transmit LED.

The housing of the cartridge is generally rectangular, but a chamfer is formed along one corner to co-operate with a bevelled edge at the station in order to ensure that the cartridge is fitted into a holder in the correct orientation to ensure alignment of the corresponding components. To assist the correct orientation of the cartridge, the top surface may be labelled as such, and the bottom surface may be labelled 'wrong way up'. The housing is weather proof, and all data transfer takes place either inductively throught the walls of the housing or by radiation passing through a housing window to and from a diode or LED.

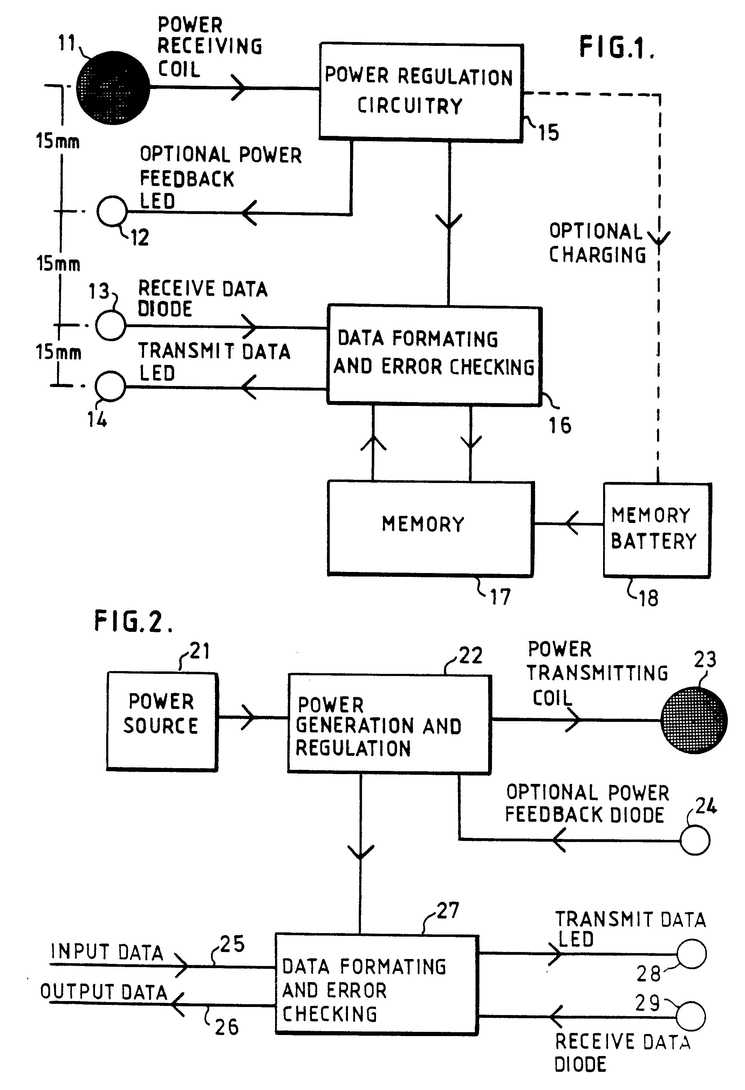

Figures 1 and 2, which are block diagrams of a cartridge and cartridge receiving station respectively, illustrate an example of the invention.

In Figure 1, the cartridge includes within its waterproof housing a power receiving coil 11, an optional power feedback diode 12, a receive data diode 13, a transmit data LED 14, power regulation circuitry 15, data formatting and error checking circuitry 16, a memory 17, and a battery 18.

In Figure 2, the cartridge holder has a power source 21, a power generation and regulation device 22, a power transmitting coil 23, an optional power feedback diode 24, a data input line 25, a data output line 26, a data formatting and error checking device 27, a transmit data LED 28 and a receive data diode 29.

When the cartridge of Figure 1 is 'docked' in the holder of Figure 2, the power source 21 energises the power generator 22 to energise the coil 23. A voltage is induced in the coil 11 through the cartridge housing without the need for exposed electrical contacts. The feedback LED 12 and the diode 24 may be used to control the power transfer, for example causing the transfer to be stopped by an increasing energisation of the LED 12 by the power regulation circuitry 15. A proximity sensor may be provided in the holder to start the power transfer automatically when the cartridge is 'docked' in the holder.

At the remote recording station, recorded data is fed on input line 25, formatted and checked in 27 and is applied to diode 28 under the energisation of circuit 22. Data passes as radiation (infra red or visible) through windows in the holder and cartridge housing to th diode 13, where after formatting and checking in device 16 which is energised by circuit 15 it passes to the memory 17, which is energised by the battery 18. Battery 18 may be rechargable by the circuit 15.

When the cartridge with its memory containing data is transferred to a holder at the central processing station, the power transfer step is repeated. Data from the memory 17 passes via the formatting and checking circuit 16 to the transmitting LED 14 from which it passes through the windows to the receive diode 29 which feeds it via the formatting and checking circuit 27 to the data output line 26 leading to the central data processor.

The coil axis and diode locations are at standard separations, so that the same cartridge can be used to transfer data at remote and central locations.

While transmission and reception of data have been effected in the described embodiment by means of electromagnetic radiation transmission/reception, this is not to be construed as limitative and other radiative sources/receivers, for example ultrasonic transducers may be used.

## Claims

1. A data storage device having a data input circuit (13, 16), a data output circuit (14, 16) and a power supply circuit (11, 12, 15), all housed in a housing, characterized in that the power supply circuit (11, 12, 15) comprises means (11) located internally of the housing without a connection to the exterior of the housing for receiving power from outside the housing by transfer through the housing.

2. A device as claimed in Claim 1 wherein said means comprises a coil (11) for receiving power from outside the housing by induction.

3. A device as claimed in Claim 1 or Claim 2 wherein the data output circuit comprises a radiation transmission element (14) disposed adjacent said housing for transmitting data output signals through the housing.

4. A device as claimed in Claim 3 wherein the radiation transmission element (14) comprises a radiation emitting diode (14) which is disposed adjacent a window in the housing.

5. A device as claimed in Claim 3 wherein the radiation transmission element (14) comprises an ultrasonic transducer.

6. A device as claimed in any one of the preceding claims wherein the data input circuit comprises a radiation receiving element (13) disposed adjacent said housing for receiving data input signals through said housing.

7. A device as claimed in Claim 6 wherein the radiation receiving element (13) comprises a radiation receiving diode (13) which is disposed adjacent a window in the housing.

8. A device as claimed in Claim 6 wherein the radiation receiving element (13) comprises an ultrasonic transducer.

9. A device as claimed in any one of the preceding claims wherein the power supply circuit further comprises a radiation transmission element (12) disposed adjacent said housing for transmitting a power supply status signal through the housing.

10. In combination, a data storage device as claimed in any one of the preceding claims and a host device, the host device including means (21, 22, 23, 24) for transferring power to the power receiving means (11) of the data storage device.

11. A combination as claimed in Claim 10 wherein the host device further indicates means (27, 28, 29) for transferring signals to the data input circuit (13, 16) and from the data output circuit (14, 16) without a connection to the housing of the data storage device.

12. A combination as claimed in Claim 10 or Claims 11 whrein the data storage device and host device have formations allowing interaction in only a single relative orientation.

13. A data storage device having a data input circuit (13, 16), a data output circuit (14, 16) and a power supply circuit (11, 12, 15), all contained in a housing having an end wall, characterized in that the power supply circuit (11, 12, 15) comprises a coil (11) within the housing having an axis extending through the end wall, the data input circuit (13, 16) comprises a diode (13) whose light receiving path extends through the end wall and the data output circuit (14, 16) comprises an LED (14) whose light emitting path extends through the end wall, the points of intersection of the paths of the diodes (13, 14) with the end wall being a first distance apart and the point of intersection of the axis of the coil (11) with the end wall being a second distance from one of the other points of intersection.

**FIG.1.**

POWER RECEIVING COIL

11

15mm

15mm

15mm

POWER REGULATION CIRCUITRY — 15

OPTIONAL POWER FEEDBACK LED

12

13 RECEIVE DATA DIODE

TRANSMIT DATA LED

14

DATA FORMATING AND ERROR CHECKING — 16

MEMORY — 17

MEMORY BATTERY — 18

OPTIONAL CHARGING

**FIG.2.**

POWER SOURCE — 21

POWER GENERATION AND REGULATION — 22

POWER TRANSMITTING COIL — 23

OPTIONAL POWER FEEDBACK DIODE — 24

INPUT DATA — 25

OUTPUT DATA — 26

DATA FORMATING AND ERROR CHECKING — 27

TRANSMIT DATA LED

28

RECEIVE DATA DIODE

29

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4 ) |
|---|---|---|---|
| X | EP-A-0055639 (D. SAULNIER)<br>* abstract *<br>* page 8, line 40 - page 11, line 10 * | 1-3,<br>10-12 | G11C5/00<br>G11B33/12<br>H04B5/00<br>H02J17/00 |
| X | IBM TECHNICAL DISCLOSURE BULLETIN.<br>vol. 29, no. 9, February 1987, NEW YORK US<br>page 3949 - 3950;<br>"Acoustically Coupled Smart Card"<br>* the whole document * | 1, 3, 5,<br>6, 8,<br>10-12 | |
| X | EP-A-0041668 (ASEA AB)<br>* abstract; figure 1 * | 1, 3, 4,<br>6, 7 | |
| X | GB-A-2189361 (THE GENERAL ELECTRIC COMPANY)<br>* page 1, line 89 - page 2, line 18; figure 1 * | 1, 3, 4,<br>6, 7 | |
| X | PATENT ABSTRACTS OF JAPAN<br>vol. 11, no. 127 (E-501)(2574) 21 April 1987,<br>& JP-A-61 273031 (NIPPON DENZAI KOGYO KENKYUSHO)<br>* see the whole document * | 1, 13 | |

TECHNICAL FIELDS
SEARCHED (Int. Cl.4 )

H02J
H04B
G11B
G11C

The present search report has been drawn up for all claims

| Place of search | Date of completion of the search | Examiner |
|---|---|---|
| THE HAGUE | 21 JUNE 1989 | HELOT H.V. |

EPO FORM 1503 03.82 (P0401)